Europäisches Patentamt

European Patent Office

Office européen des brevets

(19)

(11) **EP 0 920 025 B1**

(12) **EUROPEAN PATENT SPECIFICATION**

(45) Date of publication and mention
of the grant of the patent:
**11.02.2004 Bulletin 2004/07**

(51) Int Cl.$^7$: **G11C 11/40**, G11C 11/412

(21) Application number: **97120943.2**

(22) Date of filing: **28.11.1997**

(54) **A low power RAM memory cell**

RAM-Speicherzelle mit niedriger Leistungsaufnahme

Cellule de mémoire RAM à consommation réduite

(84) Designated Contracting States:
**DE FR GB IT**

(43) Date of publication of application:
**02.06.1999 Bulletin 1999/22**

(73) Proprietor: **STMicroelectronics S.r.l.**
**20041 Agrate Brianza (Milano) (IT)**

(72) Inventors:
• **Tooher, Michael**
**Stuttgart (DE)**
• **Tonello, Stefano**
**1-36042 Breganze (Vicenza) (IT)**

(74) Representative: **Botti, Mario**
**Botti & Ferrari S.r.l.,**
**Via Locatelli, 5**
**20124 Milano (IT)**

(56) References cited:
**EP-A- 0 359 204**          **DE-A- 4 128 919**
**GB-A- 2 107 541**          **US-A- 3 971 004**
**US-A- 5 132 929**          **US-A- 5 289 432**
**US-A- 5 301 147**          **US-A- 5 621 693**

• **PATENT ABSTRACTS OF JAPAN vol. 009, no.
161 (P-370), 5 July 1985 & JP 60 038796 A
(HITACHI SEISAKUSHO KK), 28 February 1985,**
• **PATENT ABSTRACTS OF JAPAN vol. 010, no.
177 (P-470), 21 June 1986 & JP 61 024092 A
(TOSHIBA CORP), 1 February 1986,**

## Description

Background of the invention

The present invention relates to a low power RAM memory cell for a memory matrix comprising a plurality of word-lines and bit-lines, said cell including a first and a second cross-coupled CMOS inverters each including a PMOS pull-up transistor and an NMOS pull-down transistor, and first and second access transistors connecting the second and the first inverter to a corresponding bit line respectively.

The invention relates to integrated memory circuits and more specifically, but not exclusively, to integrated static random access memories.

As is well known, an electronic random access memory device includes a plurality of basic memory cells each comprising six transistors.

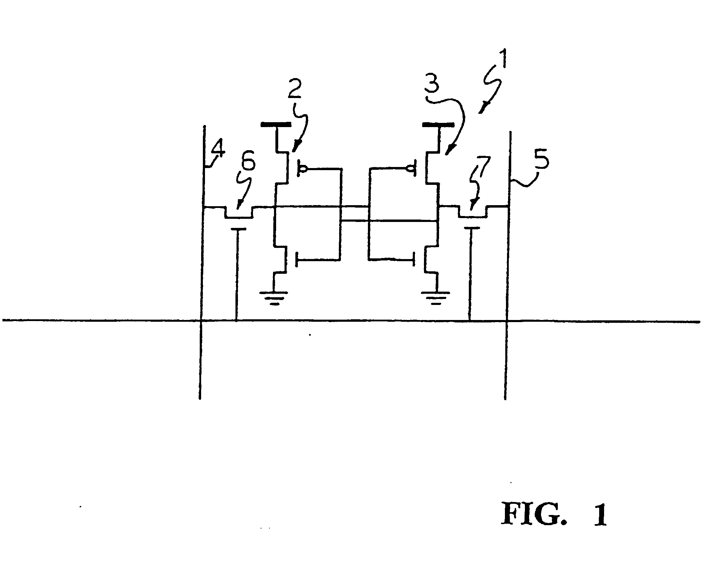

The enclosed figure 1 shows an example of a basic six transistors memory cell which is realized by CMOS technology. The cell 1 shown in figure 1 includes a pair of cross-coupled CMOS inverters 2 and 3 each of which is coupled to a corresponding bit line 4, 5 of the memory device. The first inverter 2 is coupled to the bit line 4 through a bi-directional access devices 6 while the second inverter 3 is coupled to the adjacent bit line 5 through a second bi-directional access devices 7.

During the reading and writing phases of the memory cell, a differential voltage must be applied between the bit lines 4, 5. In this respect, we might consider the cell access to the storage node as "differential".

In the reading phase, the bit line swing amplitude depends on how long the cells have been activated. The voltage difference due to the swing can be kept quite small and can be sensed by the sense amplifier of the memory device. This helps to reduce power consumption.

In the writing phase, the bit line voltage swing should be as large as possible, even a full CMOS level, in order to toggle the cells.

If we consider a RAM memory array or matrix having m rows and n columns, and including six transistors cells, the current consumption can be easily estimated using the following formulas:

$$Iddr = n * m * Cb * \Delta Vr \qquad (1)$$

for the reading phase, and

$$Iddw = n * m * Cb * \Delta Vw \qquad (2)$$

for the writing phase;
where: Cb is the bit line capacitance associated to a given cell; $\Delta Vr$ is the read voltage bit line swing and $\Delta Vw$ is the write voltage bit line swing. Usually $\Delta Vw$ corresponds to the supply voltage value Vdd.

Some prior art techniques are used to reduce the power dissipation of the memory matrix.

For instance, a first prior art solution is disclosed in: N. Kushiyama et al. "A 295 Mhz CMOS 1M (x256) embedded SRAM using I-directional read/write shared sense amplifiers and self-timed pulsed word-line drivers", ISSCC Dig. Tech. Papers Feb. 1995, pp. 182-183.

This solution proposes to reduce power dissipation by reducing the number of cells hung on the bit line using a hierarchical bit line scheme.

A second prior art solution is disclosed in: B. Amrutur and H. Horowitz "Technique to reduce power in fast wide memories" Dig. Tech. Papers, Oct. 1994, Symp. on Low Power Electronics, pp 92-93.

This second solution proposes to reduce power dissipation limiting the read bit line swing by controlling the word line pulse length.

A third prior art solution is disclosed in: T. Blalock and R. Jager " A high-speed clamped bit line current-mode sense amplifiers" IEEE J. Solid State Circuits, vol. 26, No. 4, pp. 542-548, April 1991.

Even this solution proposes to reduce power dissipation limiting the read bit line swing, but using current-mode sense amplifiers.

A further known solution proposes to limit the write bit line swing to a predetermined value, namely Vdd-Vt, using a NMOS transistors precharge phase.

One object of the present invention is that of providing a SRAM memory device having a reduced power consumption.

Another object of the present invention is that of achieving a reduction in the power dissipation of memory devices having very long wordlenght.

A further object of the present invention is that of providing a technique to reduce voltage swing on the memory array bit lines during the writing phase.

A further object of the present invention is that of providing an SRAM memory cell which doesn't require special techniques to be written.

Summary of the invention

The solution idea behind this invention is that of precharging the source terminals of the pull-down transistors forming the inverters pair inside the cell.

As an alternative, it would be possible to precharge the source terminals of the pull-up transistors forming the inverters pair inside the cell.

According to this solution idea, the technical problem is solved by a RAM memory cell according to the claims 1 or 5.

The features and advantages of the RAM memory cell according to the invention will be appreciated by the following description of a preferred embodiment given by way of non-limiting example with reference to the annexed drawings.

Brief description of the drawings

Figure 1 shows a simplified schematic diagram of a conventional and known CMOS SRAM memory cell;

Figure 2 shows a simplified schematic diagram of a CMOS RAM memory cell according to the present invention;

Figure 3 shows a schematic diagram of a memory array including a plurality of the memory cells of figure 2;

Figure 4 shows a schematic timing diagram of the electric signals inside the memory cell of figure 2 during a write operation;

Figure 5 shows a simplified schematic diagram of a second embodiment of the RAM memory cell according to the present invention;

Figure 6 shows a simplified schematic diagram of a third embodiment of the RAM memory cell according to the present invention;

Figure 7 shows a simplified schematic diagram of a fourth embodiment of the RAM memory cell according to the present invention;

Figure 8 shows a 'further schematic diagram of a dual port embodiment of the RAM memory cell according to the present invention.

Detailed description

With reference to the above figures, a static random access memory cell according to the present invention is globally indicated with 10. The cell 10 is realized by a CMOS process.

The SRAM cell according to the present invention is specifically designed for a random access electronic memory device having a six transistors cell.

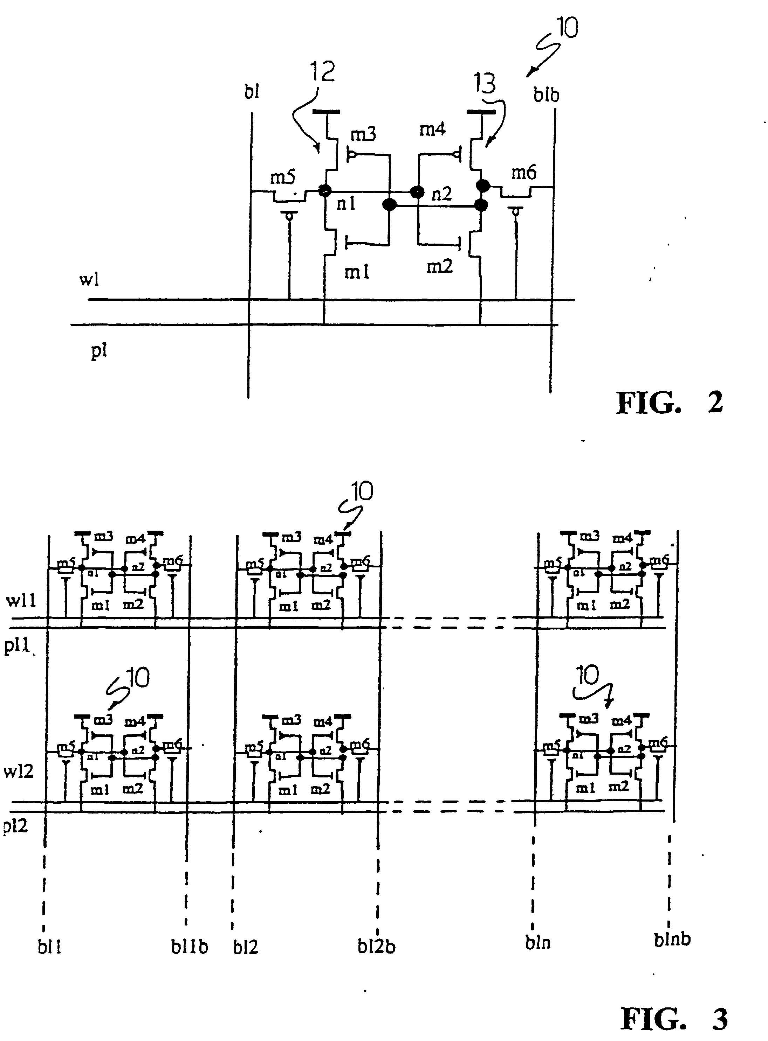

Each cell 10 is integrated in a memory array or matrix (partially shown in figure 3) including a plurality m of memory rows and a plurality n of memory columns.

The memory rows are identified as word lines WL of the memory device, while the memory columns are the bit lines BL of the memory device. Each cell 10 may be identified at the intersection between a word line WL and a couple of two adjacent bit lines BL and BLB.

The memory cell 10 comprises a couple of CMOS inverters 12 and 13 each including a pull-up PMOS transistor and a pull-down NMOS transistor. The two inverters 12, 13 are cross-coupled since the interconnection node between two transistors of one inverter is connected to the driving terminals of the other inverter.

The first inverter 12 comprises a PMOS transistor M3 and an NMOS transistor M1. The second inverter 13 comprises a PMOS transistor M4 and an NMOS transistor M2.

The transistors M1 and M3 of the first inverter 12 have their corresponding gate terminals connected to a first circuit internal node N1 which is connected to the drain common terminals of the other inverter 13.

The transistors M2 and M4 of the second inverter 13 have their corresponding gate terminals connected to a second circuit internal node N2 which is connected to the drain common terminals of the other inverter 12.

The source terminals of the PMOS transistors M3, M4 of the first and second inverters 12, 13 are both connected to a voltage supply line Vdd.

According to the present invention, the source terminals of the NMOS transistors M1, M2 of the first and second inverters 12, 13 are both connected to a precharge line PL.

This precharge line PL is an extra line which is common to all the cells 10 of a word line.

Therefore, according to the present invention the source of the driver transistors M1, M2 , instead of being grounded, are connected to the external precharge line PL.

According to a further aspect of the present invention, the second circuit node N2 is connected to the bit line BL through an access PMOS transistor M5.

This PMOS transistor M5 has the conduction terminals connected between the circuit node N2 and the corresponding bit line and the gate terminal connected to the word line WL.

Accordingly, the first circuit node N1 is connected to the bit line BLB through an access PMOS transistor M6.

Even this PMOS transistor M6 has the conduction terminals connected between the circuit node N1 and the adjacent bit line and the gate terminal connected to the word line WL.

Figure 3 shows a schematic diagram of the inside structure of the memory matrix including the plurality of cells 10 according to the present invention.

When the cell is not accessed, and during the reading phase, the precharge line PL is tied to ground. So, read operation is performed in the conventional manner.

The choice of using the PMOS access transistors M5, M6 doesn't effect the data transfer from the memory cell into the bit line.

Let's now consider the writing phase of the memory device. The write operation is performed in three steps or phases:

1) a pulse is applied to the precharge line PL. This pulse resets the internal nodes N1 and N2 of the cells 10 of an addressed word line.

The node which had been at a low logic value is now brought to the voltage level Vdd - Vtn by either the NMOS driver transistors M1 or M2.

The current path to ground is broken.

2) A small voltage difference is applied on to the bit lines BL and BLB. The smaller the voltage difference, the more power is saved.

3) The word line WL is asserted, that is: a negative pulse is due to the PMOS access transistors M5, M6. Since no current path to ground is available, the bit lines can easily pass a small voltage difference onto the internal nodes N1, N2.

The PMOS access transistors M5 and M6 allow the transfer of a small voltage difference having a value centered around the supply voltage Vdd.

On the contrary, prior art solutions including NMOS access transistors provide a voltage difference between the bit lines which is larger than the threshold voltage of a NMOS transistor.

4) The precharge line PL is disabled and the memory cell 10 now acts as a latch-type sense amplifier.

As the potential on the precharge line PL moves back toward zero volts, the symmetric nodes N1 and N2 become unstable and latch in direction of the small voltage difference which appears on them.

5) The word line WL goes to an inactive high logic state. This disconnects the memory cell from the outside world and is the end of the write operation.

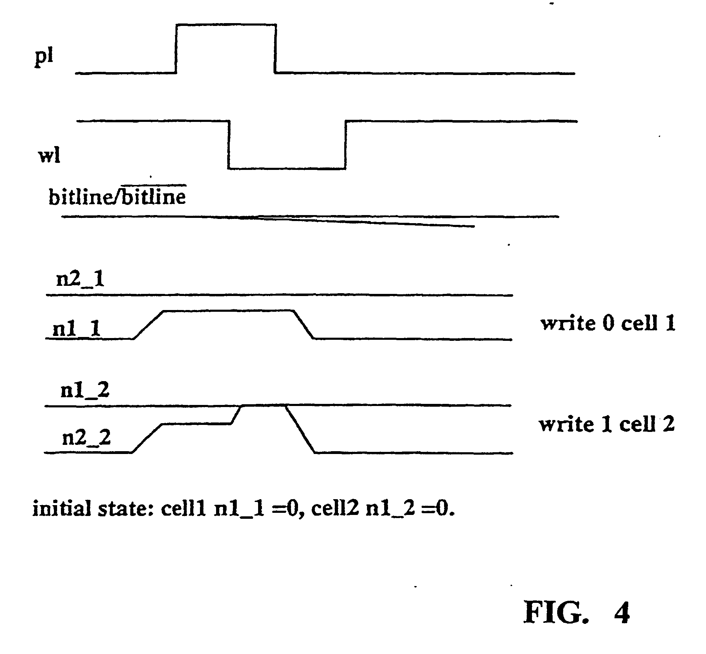

Figure 4 reports the timing diagrams of the whole write operation. These diagrams relate to the programming or write phase of a couple of memory cells.

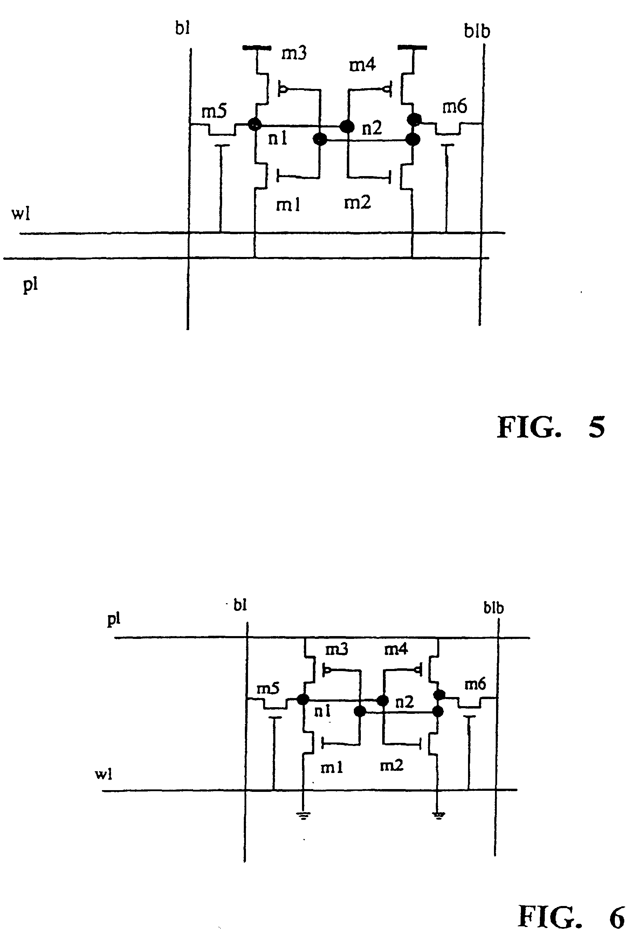

A second embodiment of the RAM memory cell according to the present invention is shown in the simplified schematic diagram of figure 5.

As may be appreciated, in this specific embodiment the access transistors M5 and M6 are NMOS transistors. This means that the provision of PMOS transistors as access transistors is an advantage but not an essential feature of the present invention.

According to this second embodiment the bit lines are precharged low between each operation of the memory cell, while the internal nodes N1 and N2 are precharged high before a write operation.

Figure 6 shows a simplified schematic diagram of a third embodiment of the RAM memory cell according to the present invention.

In this third embodiment the source terminals of the pull-up transistors M3 and M4 are connected to the precharge line PL running parallel to each word line. The source terminals of the pull-down transistors M1 and M2 are connected to the ground voltage reference.

According to this third embodiment the bit lines are precharged low between each operation of the memory cell, while the internal nodes N1 and N2 are precharged low before a write operation.

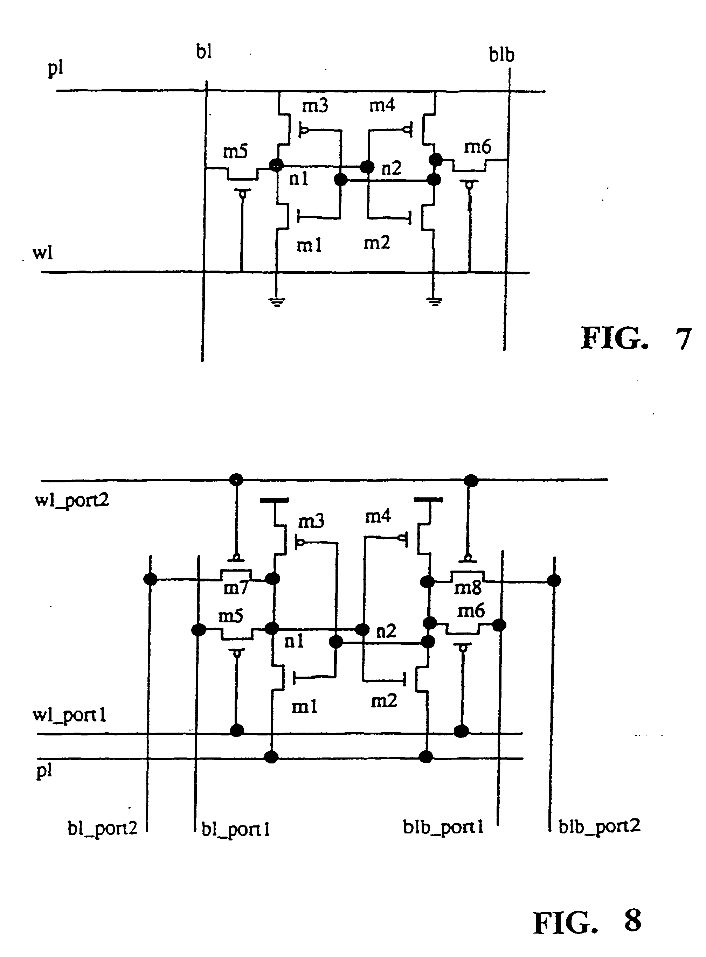

Figure 7 shows a simplified schematic diagram of a fourth embodiment of the RAM memory cell according to the present invention.

The structure of the memory cell according to this fourth embodiment corresponds substantially to the previous example of figure 6, but with the provision of PMOS transistors as access transistors.

So, the source terminals of the pull-up transistors M3 and M4 are connected to the precharge line PL and, as in the first embodiment, the PMOS transistor M5 has the conduction terminals connected between the circuit node N2 and the corresponding bit line and the gate terminal connected to the word line WL. The other PMOS access transistor M6 has the conduction terminals connected between the circuit node N1 and the corresponding bit line and the gate terminal connected to the word line WL.

The bit lines are precharged high between each operation of the memory cell, while the internal nodes N1 and N2 are precharged low before a write operation.

Figure 8 shows a further schematic diagram of a dual port embodiment of the RAM memory cell according to the present invention.

As may be appreciated, this dual port solution provides a memory cell which is interconnected to a pair of word lines, WL_PORT1 and WL_PORT2, and to a double pair of bit lines, BL_PORT1, BL_PORT2; BLB_PORT1, BLB_PORT2.

The first word line WL_PORT1 and the first bit lines BL_PORT1, BLB_PORT1 are connected to the memory cell as in the first embodiment of figure 2.

A second pair of PMOS access transistors M7 and M8 is provided to connect the cell to the second word line WL_PORT2 and to the second bit lines BL_PORT2, BLB_PORT2.

The second circuit node N2 is connected to the second bit line BL_PORT1 through the access PMOS transistor M7.

This PMOS transistor M7 has the conduction terminals connected between the circuit node N2 and the corresponding bit line and the gate terminal connected to the second word line WL_PORT2.

Accordingly, the first' circuit node N1 is connected to the other second bit line BLB_PORT2 through the access PMOS transistor M8.

Even this PMOS transistor M8 has the conduction terminals connected between the circuit node N1 and the adjacent bit line and the gate terminal connected to the second word line WL_PORT2.

A simultaneous read and write operation from the two ports PORT1, PORT2 to the same cell is not allowed.

The RAM memory cell according to the invention has the' great advantage of allowing a reduction of the power consumption.

This advantage is specifically evident for memory structures having a very long wordlenght.

**Claims**

**1.** A RAM memory cell (10) for a memory matrix comprising a plurality of word-lines (WL) and bit-lines (BL), said cell (10) including a first and a second cross-coupled CMOS inverters (12, 13), each including a PMOS pull-up transistor (M3, M4) and an NMOS pull-down transistor (M1, M2), and first and second access transistors (M5, M6) connecting the second (13) and the first inverter (12) to a corresponding bit line respectively, **characterized in that** the source terminals of the pull-down transistors (M1, M2) are connected to a precharge line (PL) which is common to all the cells (10) of a word line of said memory matrix.

2. A RAM memory cell according to claim 1, **characterized in that** said first and second access transistors (M5. M6) are PMOS transistors.

3. A RAM memory cell according to claim 2, **characterized in that** the gate terminals of said PMOS access transistors (M5, M6) are connected to the word line (WL).

4. A RAM memory cell according to claim 1, **characterized in that** said precharge line (PL) is an extra line which is common to all the cells (10) of a word line.

5. A RAM memory cell (10) for a memory matrix comprising a plurality of word-lines (WL) and bit-lines (BL), said cell (10) including a first and a second cross-coupled CMOS inverters (12, 13), each including a PMOS pull-up transistor (M3, M4) and an NMOS pull-down transistor (M1, M2), and first and second access transistors (M5, M6) connecting the second (13) and the first inverter (12) to a corresponding bit line respectively, **characterized in that** the source terminals of the pull-up transistors (M3, M4) are connected to a precharge line (PL) which is common to all the cells (10) of a word line of said memory matrix.

6. A RAM memory cell according to claim 5, **characterized in that** said first and second access transistors (M5. M6) are PMOS transistors.

7. A RAM memory cell according to claim 6, **characterized in that** the gate terminals of said PMOS access transistors (M5, M6) are connected to the word line (WL).

8. A RAM memory cell according to claim 1, wherein the cell is a static RAM.

9. A RAM memory cell according to claim 2, wherein the cell is a dual port RAM.

10. A RAM memory cell according to claim 9, **characterized in that** a further pair of PMOS access transistors (M7, M8) is provided between the first and second CMOS inverters and a corresponding second bit line (BL_PORT2, BLB_PORT2).

**Patentansprüche**

1. RAM-Speicherzelle (10) für eine Speichermatrix, umfassend mehrere Wortleitungen (WL) und Bitleitungen (BL), wobei die Zelle (10) einen ersten und einen zweiten kreuzgekoppelten CMOS-Inverter (12, 13), von denen jeder einen PMOS-Pullup-transistor (M3, M4) und einen NMOS-Pulldown-Transistor (M1, M2) aufweist, und einen ersten und einen zweiten Zugriffstransistor (M5, M6) umfasst, die den zweiten (13) und den ersten Inverter (12) jeweils mit einer entsprechenden Bitleitung verbinden, **dadurch gekennzeichnet, dass** die Quellanschlüsse der Pull-down-Transistoren (M1, M2) mit einer Vorladungsleitung (PL) verbunden sind, die alle Zellen (10) einer Wortleitung der Speichermatrix gemeinsam haben.

2. RAM-Speicherzelle nach Anspruch 1, **dadurch gekennzeichnet, dass** der erste und der zweite Zugriffstransistor (M5, M6) PMOS-Transistoren sind.

3. RAM-Speicherzelle nach Anspruch 2, **dadurch gekennzeichnet, dass** die Gate-Anschlüsse der PMOS-Zugriffstransistoren (M5, M6) mit der Wortleitung (WL) verbunden sind.

4. RAM-Speicherzelle nach Anspruch 1, **dadurch gekennzeichnet, dass** die Vorladungsleitung (PL) eine zusätzliche Leitung ist, die alle Zellen (10) einer Wortleitung gemeinsam haben.

5. RAM-Speicherzelle (10) für eine Speichermatrix, umfassend mehrere Wortleitungen (WL) und Bitleitungen (BL), wobei die Zelle (10) einen ersten und einen zweiten kreuzgekoppelten CMOS-Inverter (12, 13), von denen jeder einen PMOS-Pull-up-transistor (M3, M4) und einen NMOS-Pulldown-Transistor (M1, M2) aufweist, und einen ersten und einen zweiten Zugriffstransistor (M5, M6) umfasst, die den zweiten (13) und den ersten Inverter (12) jeweils mit einer entsprechenden Bitleitung verbinden, **dadurch gekennzeichnet, dass** die Quellanschlüsse der Endtransistoren (M1, M2) mit einer Vorladungsleitung (PL) verbunden sind, die alle Zellen (10) einer Wortleitung der Speichermatrix gemeinsam haben.

6. RAM-Speicherzelle nach Anspruch 5, **dadurch gekennzeichnet, dass** der erste und der zweite Zugriffstransistor (M5, M6) PMOS-Transistoren sind.

7. RAM-Speicherzelle nach Anspruch 6, **dadurch ge-**

**kennzeichnet, dass** die Gate-Anschlüsse der PMOS-Zugriffstransistoren (M5, M6) mit der Wortleitung (WL) verbunden sind.

8.  RAM-Speicherzelle nach Anspruch 1, wobei die Zelle ein statischer RAM ist.

9.  RAM-Speicherzelle nach Anspruch 2, wobei die Zelle ein Dualport-RAM ist.

10. RAM-Speicherzelle nach Anspruch 9, **dadurch gekennzeichnet, dass** ein weiteres Paar PMOS-Zugriffstransistoren (M7, M8) zwischen dem ersten und dem zweiten CMOS-Inverter und einer entsprechenden zweiten Bitleitung (BL_PORT2, BLB_PORT2) vorgesehen ist.


**Revendications**

1.  Cellule de mémoire vive (10) pour une matrice de mémoire comprenant une pluralité de lignes de mot (WL) et de lignes de bit (BL), ladite cellule (10) comprenant un premier et un second inverseurs CMOS à couplage transversal (12, 13), comprenant chacun un transistor de rappel vers le niveau haut PMOS (M3, M4) et un transistor de rappel vers le niveau bas NMOS (M1, M2), et des premier et second transistors d'accès (M5, M6) connectant le second (13) et le premier inverseur (12) à une ligne de bit correspondante, respectivement, **caractérisée en ce que** les bornes de source des transistors de rappel vers le niveau bas (M1, M2) sont connectées à une ligne de précharge (PL) qui est commune à toutes les cellules (10) d'une ligne de mot de ladite matrice de mémoire.

2.  Cellule de mémoire vive selon la revendication 1, **caractérisée en ce que** lesdits premier et second transistors d'accès (M5, M6) sont des transistors PMOS.

3.  Cellule de mémoire vive selon la revendication 2, **caractérisée en ce que** les bornes de grille desdits transistors d'accès PMOS (M5, M6) sont connectées à la ligne de mot (WL).

4.  Cellule de mémoire vive selon la revendication 1, **caractérisée en ce que** ladite ligne de précharge (PL) est une ligne supplémentaire qui est commune à toutes les cellules (10) d'une ligne de mot.

5.  Cellule de mémoire vive (10) pour une matrice de mémoire comprenant une pluralité de lignes de mot (WL) et de lignes de bit (BL), ladite cellule (10) comprenant un premier et un second inverseurs CMOS à couplage transversal (12, 13), comprenant chacun un transistor de rappel vers le niveau haut PMOS (M3, M4) et un transistor de rappel vers le niveau bas NMOS (M1, M2), et des premier et second transistors d'accès (M5, M6) connectant le second (13) et le premier inverseur (12) à une ligne de bit correspondante, respectivement, **caractérisée en ce que** les bornes de source des transistors de rappel vers le niveau haut (M3, M4) sont connectées à une ligne de précharge (PL) qui est commune à toutes les cellules (10) d'une ligne de mot de ladite matrice de mémoire.

6.  Cellule de mémoire vive selon la revendication 5, **caractérisée en ce que** lesdits premier et second transistors d'accès (M5, M6) sont des transistors PMOS.

7.  Cellule de mémoire vive selon la revendication 6, **caractérisée en ce que** les bornes de gâchette desdits transistors d'accès PMOS (M5, M6) sont connectées à la ligne de mot (WL).

8.  Cellule de mémoire vive selon la revendication 1, dans laquelle la cellule est une mémoire vive (RAM) statique.

9.  Cellule de mémoire vive selon la revendication 1, dans laquelle la cellule est une mémoire vive (RAM) à port double.

10. Cellule de mémoire vive selon la revendication 9, **caractérisée en ce qu'**une paire supplémentaire de transistors d'accès PMOS (M7, M8) est disposée entre les premier et second inverseurs CMOS et une seconde ligne de bit correspondante (BL_PORT2, BLB_PORT2).

**FIG. 1**

**FIG. 2**

**FIG. 3**

initial state: cell1 n1_1 =0, cell2 n1_2 =0.

FIG. 4

FIG. 5

FIG. 6

pl

bl                              blb

m3      m4

m5

n1      n2

m6

wl

m1      m2

**FIG.  7**

wl_port2

m3      m4

m7

m5      n1      n2

m8
m6

wl_port1

m1      m2

pl

bl_port2      bl_port1          blb_port1      blb_port2

**FIG.  8**